# EUROPEAN PATENT SPECIFICATION

(11) **EP 2 490 251 B1**
(45) Date of publication and mention of the grant of the patent: **23.08.2017**
(21) Application number: 09850414.5
(22) Date of filing: 16.10.2009
(51) Int. Cl.: H01L 21/58

(54) **DIE ATTACH FILM**
FILM FÜR CHIPMONTAGE
COUCHE MINCE DE FIXATION DE PUCE

(43) Date of publication of application: 22.08.2012
(73) Proprietor: LG Chem, Ltd., Youngdungpo-gu Seoul 150-721 (KR)
(72) Inventor: JOO, Hyo Sook, Daejeon 302-280 (KR); CHANG, Suk Ky, Daejeon 305-370 (KR); PARK, Hyo Soon, 305-380, Daejeon (KR); HONG, Jong Wan, Daejeon 305-340 (KR); CHO, Hyun Ju, Gimhae-si Gyeongsangnam-do 621-906 (KR); KIM, Jang Soon, Daejeon 305-772 (KR); PARK, Yong Su, Daejeon 305-340 (KR)
(74) Representative: Goddar, Heinz J.
(86) International application number: PCT/KR2009/005974
(87) International publication number: WO 2011/046238

(56) References cited:
- WO-A1-2008/133472
- WO-A1-2009/075472
- KR-A- 20060 033 726
- KR-A- 20080 036 724
- KR-A- 20090 070 893

## Description

### BACKGROUND

### 1. Field of the Invention

The present invention relates to a die attach film, a semiconductor wafer, and a semiconductor packaging method.

### 2. Related Art

With the recent tendency toward high integration and functionality of semiconductor memories used in cellular phones or mobile terminals, a method of stacking a plurality of semiconductor chips on a semiconductor substrate using a die attach film has been frequently employed.

KR20060033726, KR20090070893 and KR20080036724 disclose dicing die bond sheets.

The die attach film includes a pressure-sensitive adhesive layer for fixing a semiconductor chip during a dicing process, and an adhesive layer which is bonded to the backside of a semiconductor chip and attached to a wiring substrate such as a lead frame in a die bonding process.

A packaging process using die attach films generally includes a dicing process of cutting a wafer into separate chips, a die bonding process of bonding the diced chips to a circuit film or a lead frame, a wire bonding process of connecting a chip pad provided on the semiconductor chip with a circuit pattern of the circuit film or the lead frame using an electrical connecting means such as a wire, and a molding process of encapsulating the wire-bonded semiconductor chip using an encapsulating material to protect an internal circuit of the semiconductor chip and the other parts.

During the dicing process, the wafer is cut to a predetermined thickness by, for instance, a diamond wheel. When excessive pressure is applied or there is a mechanical impact, chipping caused by damage to the wafer and burrs capable of contaminating a pattern are generated. Recently, this problem has been further increased due to reduction in wafer thickness in order to reduce packaging size, and more sever dicing conditions resulting from demand for increased production efficiency. Particularly, as wafers become thinner, burrs, which have not been a problem before, are found protruding upward from a die with increasing frequency, thus remarkably lowering attachment workability of the chip, and contaminating the pattern which reduces the reliability of a package.

To reduce such burrs, most known technology has been adapted to change the physical properties of the film or parameters such as process conditions. However, when an attempt is made to inhibit burrs through adjustment of the parameters of the dicing process, expandability is reduced in the subsequent process, i.e. the die bonding process, or the chip is not easily picked up. Further, when the chip is picked up, a position error occurs when the die bonding is performed, or chipping occurs above the die due to insufficient dicing.

In the semiconductor packaging process, the chip including an adhesive layer released from the film after the dicing process is bonded to the wiring substrate (e.g. lead frame, etc.), and then the subsequent processes, including the molding process, are performed. Currently, after the die bonding process, a pre-curing process must be carried out at a high temperature. This pre-curing process is for preventing failures such as a phenomenon whereby a lower chip is pushed when another semiconductor chip is released from the film and stacked on the chip of the wiring substrate, and a phenomenon whereby the chip is deflected toward one side due to the flow of a mold resin. However, when the pre-curing process is performed, an adhesive begins to be cured, and thus embeddability is reduced with respect to the semiconductor substrate in the subsequent process. Further, the wafer or substrate is warped due to heat applied during the pre-curing process, so that failures such as bouncing may occur when the wire bonding is performed. As such, there is a possibility of greatly reducing the reliability of the semiconductor package.

### SUMMARY OF THE INVENTION

A die attach film, a semiconductor wafer using the same, and a semiconductor packaging method using the same are provided in order to overcome the problems occurring in the prior art.

One aspect of the present invention provides a die attach film, which includes a base film, a pressure-sensitive adhesive part that is formed on the base film, and an adhesive part that is formed on the pressure-sensitive adhesive part. In the die attach film, the thicknesses of the base film, the pressure-sensitive adhesive part, and the adhesive part are represented by A, B, and C, respectively, and the value of B/A ranges from 0.15 to 0.5, and the value of B/C ranges from 0.2 to 4.

Another aspect of the present invention provides a semiconductor wafer including the die attach film, wherein the adhesive part of the die attach film is attached to one surface of the wafer, and the base film or pressure-sensitive adhesive part of the die attach film is fixed to a wafer ring frame.

Still another aspect of the present invention provides a semiconductor packaging method, which includes dicing the semiconductor wafer according to the present invention, and picking up a semiconductor chip prepared through the dicing step.

### DETAILED DESCRIPTION OF EXEMPLARY EMBODIMENTS

The present invention is directed to a die attach film. The die attach film includes a base film, a pressure-sensitive adhesive part that is formed on the base film, and an adhesive part that is formed on the pressure-sensitive adhesive part.

In the die attach film, the thicknesses of the base film, the pressure-sensitive adhesive part, and the adhesive part are represented by A, B, and C, respectively, and the value of B/A ranges from 0.15 to 0.5, and the value of B/C ranges from 0.2 to 4.

Hereinafter, the die attach film of the present invention will be described in detail.

The die attach film of the present invention may be configured such that a thickness ratio (B/A) of the pressure-sensitive adhesive part (thickness: B) to the base film (thickness: A) ranges from 0.15 to 0.5, and preferably from 0.2 to 0.4. If B/A is less than 0.15, the pressure-sensitive adhesive part becomes too thin compared to the base film, and then an excessive amounts of burrs may be generated in a dicing process, or pick-up failure may occur due to poor expanding properties. If B/A is more than 0.5, an excessive amount of chipping may occur in the dicing process, or the handling characteristics of the film may be deteriorated.

The die attach film of the present invention may also be configured such that a thickness ratio (B/C) of the pressure-sensitive adhesive part (thickness: B) to the adhesive part (thickness: C) ranges from 0.2 to 4, preferably from 0.5 to 4, and most preferably from 0.5 to 3. If B/C is less than 0.2, the adhesive part for die bonding becomes too thin, and then only a die may be picked up in the pick-up process. If B/C is more than 4, workability may be excessively reduced.

As long as the relationships between the thicknesses of the layers constituting the die attach film of the present invention meet the aforementioned conditions, the kind of materials constituting each layer is not particularly restricted.

For example, as the base film included in the die attach film of the present invention, a typical plastic film or metal foil known in this field may be used. Examples of the plastic film may include, but are not limited to, one film or a combination of two or more films selected from olefin film such as polypropylene film or polyethylene film; polyester film such as polyethylene terephthalate film; polycarbonate film; polyvinyl chloride film; polytetrafluoroethylene film; polybutene film; polybutadiene film; vinyl chloride copolymer film; ethylene-vinyl acetate copolymer film; ethylene-propylene copolymer film; and ethylene-ethylacrylate copolymer film. Here, the "combination of two or more films" may refer to a film in which at least two of the aforementioned films are stacked, or a film that is made from the copolymers of the aforementioned resins. This base film may also be subjected to typical physical or chemical treatment such as matt treatment, corona discharge treatment, primer treatment or crosslinking treatment as needed.

In the present invention, a film in which the elongation properties of two axes are similar to each other may also be used as the base film. More specifically, a film in which a difference between the elongation ratio in a vertical direction (MD) and the elongation ratio in a horizontal direction (TD) is 10% or lower, and preferably 5% or lower of the elongation ratio in a vertical direction (MD), may be used.

The thickness of the base film is not particularly restricted as long as it satisfies the aforementioned relationship. For example, the base film may have a thickness ranging from approximately 10 µm to approximately 200 µm, preferably from approximately 80 µm to approximately 130 µm, more preferably from approximately 80 µm to approximately 100 µm, and most preferably from approximately 80 µm to approximately 90 µm. If the thickness of the base film is less than 10 µm, the adjustment of cutting depth may become unstable in the dicing process. If the thickness of the base film is more than 200 µm, many burrs may be generated in the dicing process, and the elongation ratio may be reduced, making the expansion incorrect.

Further, in the case where a UV (ultraviolet) curable pressure-sensitive adhesive is used for the pressure-sensitive adhesive part, the base film preferably has excellent UV transmission. For example, the UV transmittance of the base film may be 70% or more, and preferably 90% or more.

The kind of the pressure-sensitive adhesive constituting the pressure-sensitive adhesive part is not substantially restricted in the die attach film. For example, the pressure-sensitive adhesive may include a typical UV curable pressure-sensitive adhesive or a typical thermo-curable pressure-sensitive adhesive. In the case where a UV curable pressure-sensitive adhesive is used, pressure-sensitive adhesive strength may be reduced by irradiating UV from the side of the base film. In the case where a thermo-curable pressure-sensitive adhesive is used, pressure-sensitive adhesive strength may be reduced by applying appropriate heat.

In the present invention, from the standpoint of pick-up reliability, a UV curable pressure-sensitive adhesive may be used. In this case, the pressure-sensitive adhesive part may include a base resin, a UV curable compound, a photo initiator, and a cross-linking agent. In the present invention, when the pressure-sensitive adhesive part is said to include the above components, it may be interpreted that the pressure-sensitive adhesive part exists in the form of a dried, semi-cured, or cured material of a composition or a coating solution containing the above components.

An example of the base resin may include an acrylic resin. This acrylic resin may have a weight average molecular weight of 100,000 to 1,500,000, and preferably 200,000 to 1,000,000. If the weight average molecular weight is less than 100,000, coatability or cohesive force may be reduced, and thus a phenomenon whereby some residual material remains on an adherend when released or the pressure-sensitive adhesive is decomposed may occur. If the weight average molecular weight is more than 1,500,000, the base resin may hinder a reaction of the UV curable compound, and thus the pressure-sensitive adhesive strength may not be efficiently reduced.

For example, the acrylic resin may be a copolymer of a (meth)acrylic acid ester monomer and a monomer having a cross-linkable functional group.

Here, an example of the (meth)acrylic acid ester monomer may include alkyl (meth)acrylate, and more particularly, a monomer having an alkyl group with 1 to 12 carbon atom(s), an example of which may include one or a combination of two or more selected from pentyl (meth)acrylate, n-butyl (meth)acrylate, ethyl (meth)acrylate, methyl (meth)acrylate, hexyl (meth)acrylate, n-octyl (meth)acrylate, isooctyl (meth)acrylate, 2-ethylhexyl (meth)acrylate, dodecyl (meth)acrylate, and decyl (meth)acrylate. In the case of the monomer having the alkyl group, the greater the number of carbon atoms of the alkyl group, the lower the glass transition temperature of a final copolymer. Thus, the monomer may be properly selected according to a desired glass transition temperature, and the like.

Further, an example of the monomer having a cross-linkable functional group may include one or a combination of two or more selected from a monomer having a hydroxy group, a monomer having a carboxyl group, and a monomer having nitrogen. Examples of the hydroxy group-containing monomer may include, but are not limited to, 2-hydroxyethyl (meth)acrylate, 2-hydroxypropyl (meth)acrylate, and the like. Examples of the carboxyl group-containing monomer may include, but are not limited to, (meth)acrylic acid, and the like. Examples of the nitrogen-containing monomer may include, but are not limited to, (meth)acrylonitrile, N-vinyl pyrrolidone, N-vinyl caprolactam, and the like.

The acrylic resin may additionally include a low molecular weight compound containing a carbon-carbon double bond, such as vinyl acetate, styrene, or (meth)acrylonitrile as a co-monomer, for the improvement of other functions such as compatibility.

The kind of UV curable compound that can be used in the present invention is not substantially restricted. For example, the UV curable compound may be a multifunctional oligomer compound (ex. multifunctional acrylate) having a weight average molecular weight of approximately 500 to approximately 300,000. It is apparent to those skilled in the art that an oligomer suitable for a desired use can be easily selected.

The UV curable compound may be included in an amount of 5 to 400 parts by weight, and preferably 10 to 200 parts by weight, relative to 100 parts by weight of the base resin. If the amount of the UV curable compound is less than 5 parts by weight, the pick-up characteristic may be reduced because the pressure-sensitive adhesive strength is not sufficiently reduced after curing. If the amount of the UV curable compound is more than 400 parts by weight, the cohesive force of the pressure-sensitive adhesive may become insufficient before the UV light is irradiated, or release from, for instance, a release film, may become difficult.

The kind of photo initiator is not substantially restricted either, and thus a typical photo initiator known in this field may be used. The photo initiator may be included in an amount of 0.05 to 20 parts by weight, relative to 100 parts by weight of the UV curable compound. If the amount of the photo initiator is less than 0.05 parts by weight, the pick-up characteristic may be reduced because the curing reaction by the UV irradiation is insufficient. If the amount of the photo initiator is more than 20 parts by weight, the cross-linking reaction may occur in a short unit in the curing process, an unreactive UV curable compound may be generated which causes residual material to remain on the adherend, or the pick-up characteristics may be lowered due to excessive reduction in pressure-sensitive adhesive force.

Further, the kind of cross-linking agent included in the pressure-sensitive adhesive part and endowing the adhesive and cohesive forces is not substantially restricted either. The cross-linking agent may be a typical compound such as an isocyanate compound, a aziridine compound, an epoxy compound, or a metal chelate compound. The cross-linking agent may be included in an amount of 2 to 40 parts by weight, and preferably 2 to 20 parts by weight, relative to 100 parts by weight of the base resin. If the amount of the crosslinking agent is less than 2 parts by weight, the cohesive force of the pressure-sensitive adhesive may become insufficient. If the amount of the crosslinking agent is more than 40 parts by weight, the chips may be scattered due to shortage of the tack strength before the UV light is irradiated.

Further, the pressure-sensitive adhesive part of the present invention may properly include a tackifier such as a rosin, a terpene resin, a phenol resin, a styrene resin, an aliphatic petroleum resin, an aromatic petroleum resin, or an aliphatic-aromatic copolymer petroleum resin.

The thickness of the pressure-sensitive adhesive part including the aforementioned components is not substantially restricted as long as it satisfies the aforementioned thickness relationship. For example, the thickness of the pressure-sensitive adhesive part may range from approximately 10 µm to approximately 40 µm, and preferably from approximately 20 µm to approximately 30 µm.

In the present invention, the components constituting the adhesive part included in the die attach film are not substantially restricted either. However, the adhesive part used for the die bonding preferably satisfies two characteristics of warpage and stress relief of the semiconductor chip and its substrate in the package. In detail, the semiconductor chip typically has a coefficient of thermal expansion (CTE) of about 4 ppm/°C, and a semiconductor substrate typically has a CTE of about 10 ppm/°C to about 15 ppm/°C. Due to a difference between the CTEs, failure such as warpage or cracks may occur in the process. Thus, the adhesive part used in the present invention is preferably configured so as to have an excellent stress relaxation property at high temperature while preventing warpage of the product and exhibiting excellent physical properties, for instance, excellent adhesion strength, heat resistance, and the like.

In the present invention, as long as the adhesive part satisfies the aforementioned characteristics, its components are not substantially restricted. For example, the adhesive part may include an adhesive in which two or more resins having different elasticity to each other are mixed such that soft and hard segments coexist therein. Thereby, the adhesive part may have the stress relaxation characteristic capable of preventing the warpage caused by the CTE difference between the semiconductor chip and its substrate as well as excellent physical properties including excellent adhesion strength, heat resistance, and the like.

For example, the adhesive part may include an epoxy resin, a high-molecular-weight resin having low-elasticity, and a hardener. Herein, when the adhesive part is said to include these components, it may be interpreted that the adhesive part exists in a form of a dried, semi-cured, or cured material of a composition or a coating solution containing the components.

The epoxy resin that can be used in the present invention may include a typical epoxy resin for the adhesive which is known in this field. For example, the epoxy resin may contain two or more epoxy groups in a molecule and have a weight average molecular weight of 300 to 2,000. This epoxy resin may form a hard crosslinking structure through a curing process, and thus exhibit excellent adhesion strength, heat resistance, and mechanical force. More specifically, the epoxy resin used in the present invention preferably has an average epoxy equivalent of 180 to 1,000. If the average epoxy equivalent of the epoxy resin is less than 180, the die attach film may exhibit a hard characteristic on the whole due to excessively high crosslinking density. If the average epoxy equivalent of the epoxy resin is more than 1,000, the heat resistance may be reduced.

An example of this epoxy resin may include, but is not limited to, one or two or more selected from bifunctional epoxy resins such as a bisphenol A epoxy resin and a bisphenol F epoxy resin, and multifunctional epoxy resins having three or more functional groups such as a cresol novolak epoxy resin, a phenol novolak epoxy resin, a tetrafunctional epoxy resin, a biphenyl epoxy resin, a triphenolmethane epoxy resin, an alkyl-modified triphenolmethane epoxy resin, a naphthalene epoxy resin, a dicyclopentadiene epoxy resin, and a dicyclopentadiene-modified phenol epoxy resin.

Particularly, a mixed resin in which a bifunctional epoxy resin is mixed with a multifunctional epoxy resin is preferably used as the epoxy resin in the present invention. The term "multifunctional epoxy resin" as used herein refers to an epoxy resin having three or more functional groups. In general, bifunctional epoxy resins have excellent flexibility, fluidity at high-temperature, and the like, but have poor heat resistance and curing speed. By contrast, multifunctional epoxy resins having three or more functional groups have a rapid curing speed, and show excellent heat resistance due to a high crosslinking density, but are poor in flexibility and fluidity. Thus, when the two kinds of resins are properly mixed and used, it is possible to control the elastic modulus and tackiness of the adhesive part, and inhibit the scattering of chips or the occurrence of burrs in the dicing process.

When the mixed resin is used, the bifunctional epoxy resin may be preferably included in an amount of 10 to 50 parts by weight, relative to 100 parts by weight of the multifunctional epoxy resin. If the amount of the bifunctional epoxy resin is less than 10 parts by weight, the adhesion strength may be reduced at high temperature due to low tackiness. If the amount of the bifunctional epoxy resin is more than 50 parts by weight, the handling characteristics may be reduced or the occurrence of burrs may be increased in the dicing process.

Further, in the adhesive part, the epoxy resin may be included in an amount of 10 to 200 parts by weight, and preferably 20 to 100 parts by weight, relative to 100 parts by weight of the high-molecular-weight resin having low-elasticity. If the amount of the epoxy resin is less than 10 parts by weight, the heat resistance and handling characteristics may be reduced. If the amount of the epoxy resin is more than 200 parts by weight, the workability and reliability may be reduced.

The high-molecular-weight resin having low-elasticity may form soft segments within the adhesive so as to provide the stress relaxation characteristic at high temperature. Here, any resin can be used as the high-molecular-weight resin as long as it is blended with the epoxy resin, does not cause breakage when the film is formed, exhibits viscoelasticity after a crosslinking structure is formed, and has excellent compatibility with other components and excellent storage stability.

For example, the high-molecular-weight resin may be a resin whose glass transition temperature is -20°C to 40°C, and preferably -10°C to 30°C. If the glass transition temperature of the high-molecular-weight resin is lower than -20°C, the handling characteristics may be deteriorated due to excessively high fluidity. If the glass transition temperature of the high-molecular-weight resin is higher than 40°C, the adhesion strength with respect to the wafer may be reduced at low temperature, and thus chips may be scattered in the dicing process, or cooling water may penetrate between the chips.

Further, the high-molecular-weight resin may have a weight average molecular weight of 100,000 to 1,000,000, and preferably 200,000 to 900,000. If the weight average molecular weight of the high-molecular-weight resin is less than 100,000, the handling characteristics and heat resistance may be reduced, and thus the control of the fluidity may become difficult when the circuit is filled. If the weight average molecular weight of the high-molecular-weight resin is more than 1.000,000, the circuit fillability and reliability may be reduced due to an excessive increase in elastic modulus.

The detailed kind of high-molecular-weight resin having low-elasticity is not substantially restricted as long as it satisfies the aforementioned characteristics. For example, the high-molecular-weight resin may include, but is not limited to, one or a combination of two or more selected from polyimide, polyetherimide, polyesterimide, polyamide, polyethersulfone, polyetherketone, polyolefin, polyvinyl chloride, phenoxy, reactive acrylonitrilbutadiene rubber, and acrylic resin.

Here, a concrete example of the acrylic resin may be an acrylic copolymer that includes (meth)acrylic acid and its derivative as a co-monomer. Here, examples of the (meth)acrylic acid and its derivative may include: (meth)acrylic acid; alkyl (meth)acrylate containing an alkyl group with 1 to 12 carbon atom(s) such as methyl (meth)acrylate or ethyl (meth)acrylate; (meth)acrylonitrile or (meth)acrylamide; and other copolymerizable monomers.

The acrylic resin may also include one or two or more functional groups such as a glycidyl group, a hydroxy group, a carboxyl group, and an amine group. This functional group may be introduced by copolymerizing a monomer such as glycidyl (meth)acrylate, hydroxy (meth)acrylate, hydroxyethyl (meth)acrylate, or carboxy (meth)acrylate.

When the acrylic resin contains the functional group, the functional group may be preferably included in an amount of 0.5 to 10 parts by weight relative to the total weight of the acrylic resin. If the amount of the functional group is less than 0.5 parts by weight, it may be difficult to secure the adhesion strength. If the amount of the functional group is more than 10 parts by weight, the workability may be reduced or gelation may occur.

The hardener, which may be included in the adhesive part of the present invention, is not substantially restricted as long as it can react with the epoxy resin and/or the high-molecular-weight resin having low-elasticity to form the crosslinking structure. Here, for example, the hardener may be one that can simultaneously react with these two components to form the crosslinking structure. This hardener may form the crosslinking structure with each of the soft and hard segments in the adhesive, thereby improving the heat resistance. Simultaneously, the hardener may act as the crosslinking agent of the two segments on an interface of the two segments to improve the reliability of the semiconductor package.

Here, for example, the hardener may be a phenol resin that contains two or more hydroxyl groups in a molecule and has a hydroxyl value ranging from 100 to 1,000. If the hydroxyl value is less than 100, the stress relaxation characteristic of the adhesive part may be reduced. If the hydroxyl value is more than 1,000, the heat resistance may be deteriorated due to a decrease in crosslinking density.

Further, the phenol resin preferably has a softening point of 50°C to 150°C. If the softening point of the phenol resin is lower than 50°C, the handling characteristics may be reduced. If the softening point of the phenol resin is higher than 150°C, the adhesion strength between the adhesive part and the wafer may be reduced.

Examples of the phenol resin may include, but are not limited to, one or two or more selected from bisphenol A resin, phenol novolak resin, cresol novolak resin, bisphenol A novolak resin, phenol aralkyl resin, multifunctional novolak resin, dicyclopentadiene phenol novolak resin, aminotriazine phenol novolak resin, polybutadiene phenol novolak resin, and biphenyl type resin.

In the adhesive part of the present invention, the hardener may be included in an amount of 30 to 100 parts by weight, and preferably 50 to 90 parts by weight, relative to 100 parts by weight of the epoxy resin. If the amount of the hardener is less than 30 parts by weight, an amount of the unreactive epoxy resin may be increased in the curing process, and thus the heat resistance is reduced, or a high-temperature or long lasting process is required to cure the unreactive epoxy resin. If the amount of the hardener is more than 100 parts by weight, moisture absorptivity, storage stability, and dielectric characteristic may be deteriorated due to an unreactive hydroxyl group.

Further, the adhesive part of the present invention may additionally include a curing accelerator to accelerate the curing reaction. An example of the curing accelerator may include one or two or more selected from an imidazole compound, triphenylphosphine (TPP), and a tertiary amine, preferably an imidazole compound.

Examples of the imidazole compound may include, but are not limited to, one or two or more selected from 2-methyl imidazole (2MZ), 2-ethyl-4-methyl imidazole (2E4MZ), 2-phenyl imidazole (2PZ), 1-cyanoethyl-2-phenyl imidazole (2PZ-CN), 2-undecyl imidazole (C11Z), 2-heptadecyl imidazole (C17Z), and 1-cyanoethyl-2-phenylimidazole trimellitate (2PZ-CNS).

The curing accelerator may be included in an amount of 0.1 to 10 parts by weight, and preferably 0.2 to 5 parts by weight, relative to 100 parts by weight of the epoxy resin. If the amount of the curing accelerator is less than 0.1 parts by weight, the heat resistance or the adhesive force may be reduced. If the amount of the curing accelerator is more than 10 parts by weight, the curing reaction takes place too abruptly, and thus the storage stability is reduced.

Further, the adhesive part may additionally include an inorganic filler from the standpoint of the handling characteristics, heat resistance, and melt viscosity. Examples of the inorganic filler may include, but are not limited to, one or two or more selected from silica, aluminum hydroxide, calcium carbonate, magnesium hydroxide, aluminum oxide, talc and aluminum nitride.

This inorganic filler may have a average particle diameter of 0.001 µm to 10 µm, and preferably 0.005 µm to 1 µm. If the particle diameter of the inorganic filler is less than 0.001 µm, the filler may agglomerate in the adhesive part, or the appearance may be unsatisfactory. If the particle diameter of the inorganic filler is more than 10 µm, the filler may protrude from the surface of the adhesive part and chips may be damaged when hot-pressing is carried out, or an effect of enhancing the adhesive property may be reduced.

The inorganic filler may be included in an amount of 0.5 to 100 parts by weight, and preferably 5 to 50 parts by weight, relative to 100 parts by weight of total resin components in the adhesive part. If the amount of the inorganic filler is less than 0.5 parts by weight, an effect of improving the heat resistance and handling characteristics due to addition of the inorganic filler may be insufficient. If the amount of the inorganic filler is more than 100 parts by weight, the workability and the adhesion strength with respect to the substrate may be reduced.

Further, the adhesive part of the present invention may additionally include a coupling agent. Thereby, it is possible to improve the close adhesion property between the resin component and the wafer or the filler, or the moisture- and heat-proof characteristics. Examples of the coupling agent may include, but are not limited to, one or two or more selected from a silane coupling agent, a titan coupling agent, and an aluminum coupling agent.

The coupling agent may be included in an amount of 0.05 to 15 parts by weight, and preferably 0.1 to 10 parts by weight, relative to 100 parts by weight of the resin component. If the amount of the coupling agent is less than 0.05 parts by weight, the improvement of the close adhesion property may be insufficient. If the amount of the coupling agent is more than 15 parts by weight, voids may be generated or the heat resistance may be reduced.

Here, the adhesive part including the aforementioned components may have a tack force ranging from 50 gf to 150 gf at 130°C, and a shear strength of 4.0 MPa or more at 150°C.

When the adhesive part satisfies the above physical properties, there is an advantage in that the wire bonding and molding processes can be performed without a pre-curing process, which is typically performed after the die bonding process. In this manner, when the adhesive part meets these conditions, it is possible to prevent the release, shifting, or deflection of a chip in the subsequent process, without the pre-curing process in the semiconductor packaging process. Thus, it is possible to improve the embeddability of the film, reduce failures such as warpage of the wafer, and increase productivity.

If the tack force of the adhesive part is less than 50 gf, the release, shifting, or deflection of a chip may occur in the die bonding process. If the tack force of the adhesive part is more than 150 gf, many burrs may be generated in the process, or the handling characteristics or heat resistance may be reduced. Further, if the shear strength of the adhesive part is less than 4.0 MPa, the shifting of the chip may occur in the semiconductor process, and thus the reliability of the semiconductor package may be reduced.

The method of measuring the tack force and the shear strength is not substantially restricted in the present invention, and thus may be a typical method performed in this field. Here, for example, the tack force may be measured through a method using a texture analyzer and a ball type probe. The shear strength may also be measured using typical measurement equipment in this field (e.g a ball shear/wire pull test machine, DAGE 4000 series).

The thickness of the adhesive part as described above is not substantially restricted in the present invention as long as the adhesive part satisfies the aforementioned relationship. For example, the thickness of the adhesive part may range from 1 µm to 200 µm, preferably from 15 µm to 100 µm, more preferably from 20 µm to 100 µm, still more preferably from 20 µm to 70 µm, and most preferably from 20 µm to 60 µm. If the thickness of the adhesive part is less than 1 µm, the stress relaxation characteristic at high temperature and the embeddability may be reduced. If the thickness of the adhesive part is more than 200 µm, the economical efficiency is reduced.

Further, the die attach film of the present invention may additionally include a release film formed on the adhesive part.

Examples of the release film may include, but are not limited to, one or two or more selected from a polyethylene terephthalate film, a polytetrafluoroethylene film, a polyethylene film, a polypropylene film, a polybutene film, a polybutadiene film, a vinylchloride copolymer film, and a polyimide film.

A surface of this release film may be subjected to a release treatment using one or two or more selected from alkyd-, silicon-, fluorine-, unsaturated ester-, polyolefin-, and wax-based release agents. Among them, the alkyd-, silicon-, or fluorine-based release agents having high heat resistance are particularly preferable.

The release film may be typically formed at a thickness of about 10 µm to about 500 µm, and preferably about 20 µm to about 200 µm. If the thickness of the release film is less than 10 µm, the release film may undergo excessive elongation in the curing process after coating. If the thickness of the release film is more than 500 µm, the economical efficiency is reduced.

The method of manufacturing the die attach film is not particularly restricted. For example, a method of sequentially forming the pressure-sensitive adhesive part, the adhesive part, and the release film on the base film, or a method of separately forming the pressure-sensitive adhesive part and the adhesive part, and then laminating them to each other may be used.

In this method, a method of forming the adhesive part is not substantially restricted. For example, the adhesive part may be formed through a method including a 1^{st} step of dissolving or dispersing each component constituting the adhesive in a solvent to prepare a resin varnish, a 2^{nd} step of applying the resin varnish to the base film or the release film, and a 3^{rd} step of heating the base film or the release film covered with the resin varnish to remove the solvent.

In the 1^{st} step, the resin varnish is prepared using the components constituting the adhesive part. Here, the solvent may typically use one or a mixture of two or more selected from methylethylketone (MEK), acetone, toluene, dimethylformamide (DMF), methylcellosolve (MCS), tetrahydrofuran (THF), N-methylpyrrolidone (NMP), and ethyl acetate. Here, in consideration of the heat resistance of the base film, a low-boiling-point solvent may be used, or a high-boiling-point solvent may be used to improve coatability.

In the 1^{st} step, a filler may also be used to reduce the process time and improve dispersibility. In this case, the 1^{st} step may include (1) mixing a solvent, a filler, and a coupling agent, (2) adding and mixing an epoxy resin and a hardener to the mixture of step (1), and (3) mixing a high-molecular-weight resin having low-elasticity and a curing accelerator with the mixture of step (2).

Here, an example of the available filler may include one or a combination of two or more selected from a ball mill, a bead mill, three rolls, and a high-rate disperser. The material for the ball or bead may include glass, alumina or zirconium. Particularly, in the aspect of the dispersibility of particles, a ball or bead made of zirconium is preferable.

In the 2^{nd} step of forming the adhesive part, the prepared resin varnish is applied to the base film or the release film. The method of application is not substantially restricted. For example, knife coating, roll coating, spray coating, gravure coating, curtain coating, comma coating, or lip coating may be used.

In the 3^{rd} step of forming the adhesive part, the base film or the release film coated with the resin varnish is heated to remove the solvent. The 3^{rd} step may be preferably carried out at a temperature of 70°C to 250°C for 5 minutes to 20 minutes, but is not limited to these conditions.

Further, the method of forming the pressure-sensitive adhesive part is not substantially restricted in the present invention. For example, the pressure-sensitive adhesive part may be formed by dissolving or dispersing components such as an acrylic resin, a cross-linking agent, a UV curable compound, and a photo initiator in a solvent to prepare a resin varnish, and applying and drying the prepared resin varnish to a base film (or a release film).

The method of laminating the adhesive part and the pressure-sensitive adhesive part is not substantially restricted. For example, the laminating method may be a hot roll laminating method or a laminate pressing method. In the aspect of continuous process possibility and efficiency, the hot roll laminating method is preferable. The hot roll laminating method may be carried out at a pressure of 0.1 Kgf/cm² to 10 Kgf/cm² and a temperature of 10°C to 100°C.

The present invention is also directed to a semiconductor wafer including the die attach film, in which the adhesive part of the die attach film is attached to one surface of the wafer, and the base film or the pressure-sensitive adhesive part of the die attach film is fixed to a wafer ring frame.

This semiconductor wafer can be manufactured by attaching (laminating) the adhesive part of the die attach film to a backside of the semiconductor wafer at a temperature of 10°C to 180°, and fixing the base film or the pressure-sensitive adhesive part to the wafer ring frame.

The present invention is also directed to a semiconductor packaging method, which includes a 1^{st} step of dicing the semiconductor wafer of the present invention, and a 2^{nd} step of picking up a semiconductor chip prepared through the 1^{st} step.

Subsequent to the above steps, the semiconductor packaging method may further include a 3^{rd} step of bonding the picked-up semiconductor chip to the semiconductor substrate, a 4^{th} step of wire-bonding the semiconductor chip and the semiconductor substrate, and a 5^{th} step of molding the semiconductor chip using an encapsulating material.

The semiconductor packaging method of the present invention will be described below in detail. In the semiconductor packaging method, the semiconductor wafer to which the aforementioned die attach film is attached is completely cut into discrete chips using a dicing apparatus. Afterwards, the pressure-sensitive adhesive part is cured through means for applying UV light or heat. Adhesion strength between the adhesive part and the pressure-sensitive adhesive part decreases in the curing process, so that the chip is easily picked up in the subsequent process. In this case, if necessary, an expanding process of expanding the die attach film is carried out, thereby the picking up step may be easily performed by expanding the interval between the chips, and generating dislocation on the interface between the adhesive part and the pressure-sensitive adhesive part.

When the chip is picked up in the above state, the semiconductor wafer and the adhesive part are peeled off from the pressure-sensitive adhesive part, so that the chip, to which only the adhesive layer is attached, can be obtained. The obtained chip, to which the adhesive layer is attached, is attached to the semiconductor substrate. Typically, the chip is attached under the following conditions: a temperature of 100°C to 180°C, a time of 0.5 sec to 3 sec, and a pressure of 0.5 kgf/cm² to 2 kgf/cm².

After the process is carried out, the wire bonding and molding processes are carried out, so that a semiconductor device is obtained. When the adhesive part having the tack force and shear strength as described above is used according to the present invention, the release, shifting, or deflection of the chip can be inhibited in the wire bonding or molding process even though the pre-curing process after the die bonding process is not performed.

The method of manufacturing the semiconductor device is not limited to these processes, and thus may further include an arbitrary process, or change in sequence of the processes. For example, the method may be performed in the sequence of UV curing, dicing, and expanding processes, or in the sequence of dicing, expanding, and UV curing processes. After the chip attaching process, a heating or cooling process may be additionally carried out.

### EXAMPLES

Hereinafter, the present invention will be described in more detail through the following Examples and Comparative examples. However, the scope of the present invention is not restricted to the following examples.

### Preparation Example 1: Preparation of high-molecular weight resin having low-elasticity

100 parts by weight of butyl acrylate, 100 parts by weight of ethyl acrylate, 70 parts by weight of acrylonitrile, 8 parts by weight of glycidyl methacrylate, 4 parts by weight of acrylic acid, and 750 parts by weight of deionized distilled water were input into a four-port, 3L reactor having an agitator, a nitrogen substitution apparatus, and a thermometer. Then, 2 parts by weight of suspending agents (polyvinylalcohol (trademark: NH-17, manufactured by Nippon Ghosei) diluted with water to 4%) and 0.3 parts by weight of molecular weight regulators (dodecyl mercaptan) were added so as to prepare a mixture. The prepared mixture was subjected to a nitrogen substitution process for about 1 hour, and was then heated to 55°C. When the temperature reached a preset temperature, 2 parts by weight of diethylhexylperoxydicarbonate (trademark: Trigonox EHP, manufactured by Akzo Nobel) diluted with ethyl acetate to a concentration of 2 wt% was added as an initiator so as to initiate a polymerization reaction. When 4 hours had lapsed after the polymerization reaction was initiated, the polymerization reaction was terminated. Then, the reaction product was washed with deionized distilled water several times, and dried using a centrifugal separator and a vacuum oven. Thereby, polymer beads were obtained. The yield of the beads was 90%, the weight average molecular weight of the beads measured by using gel-permeation chromatography was 750,000, the molecular weight distribution of the beads was 4.0, and the glass transition temperature (Tg) of the beads was 10°C. The prepared polymer beads were sufficiently dissolved in methylethylketone for 1 day and then used.

### Example 1

### Preparation of dicing film (pressure-sensitive adhesive film)

A UV (ultraviolet) curable pressure sensitive adhesive composition was prepared by mixing 7 parts by weight of Darocur TPO as a photo initiator with a mixture including 100 parts by weight of acrylic copolymer, which was prepared by copolymerizing 2-ethylhexyl acrylate, methyl acrylate, and methyl methacrylate having a weight average molecular weight of 800,000 and a glass transition temperature of 10°C, 5 parts by weight of isocyanate hardener and 10 parts by weight of multifunctional oligomer having a weight average molecular weight of 20,000, relative to 100 parts by weight of the multifunctional oligomer. Then, the UV curable pressure-sensitive composition was coated onto a polyester film, which had been subjected to release treatment and had a thickness of 38 µm, so as to have a thickness of 20 µm after being dried, and was dried at 110°C for 3 min. Then, the dried pressure-sensitive adhesive layer was laminated on a polyolefin film as a base film having a thickness of 90 µm. Thereby, a pressure-sensitive adhesive film for dicing was prepared.

### Preparation of die attach film

75 parts by weight of YDCN-500-1P (cresol novolak epoxy resin, manufactured by KUKDO Chem. Co., Ltd., epoxy equivalent = 200, softening point = 52°C), 25 parts by weight of YD-128 (bisphenol A epoxy resin, manufactured by KUKDO Chem. Co., Ltd., epoxy equivalent = 187), 60 parts by weight of KPH-F2001 (phenol novolak resin, manufactured by Kolon Chem. Co., Ltd., hydroxyl value = 106, softening point = 88°C), 200 parts by weight of the high-molecular weight resin prepared in Preparation Example 1, 0.5 parts by weight of 2-phenyl imidazole (2PZ, manufactured by SHIKOKU Chemical Co.), 2 parts by weight of silane coupling agent, (KBM-403, manufactured by Shinetsu Chemical Co., Ltd., γ-glycydoxypropyltrimethoxysilane), and 30 parts by weight of silica filler (UFP-30, manufactured by Denka Kagaku Kogyo Co. Ltd, average particle diameter = 150 nm) were mixed and agitated in methyethylketone (MEK) so as to prepare a resin varnish. The prepared resin varnish was coated onto a base film having a thickness of 38 µm (RS-21G, silicon release PET film, manufactured by SKC), and was dried at 110°C for 5 min. Thereby, an adhesive layer for die bonding having a thickness of 20 µm was prepared. The prepared adhesive layer was laminated on the pressure-sensitive adhesive film including the UV curable pressure-sensitive adhesive layer under conditions of 40°C and 5 kgf/cm² for 5 seconds using a hot roll laminator. Thereby, a die attach film was prepared.

### Example 2

A die attach film was prepared by the same method as in Example 1, except that the pressure-sensitive adhesive film was prepared by controlling the pressure sensitive adhesive layer to have a thickness of 30 µm, and using a polyolefin film having a thickness of 80 µm.

### Example 3

A die attach film was prepared by the same method as in Example 2, except that the thickness of the adhesive layer for die bonding was controlled to be 60 µm.

### Example 4

A die attach film was prepared by the same method as in Example 2, except that the thickness of the adhesive layer for die bonding was controlled to be 10 µm.

### Comparative Example 1

A die attach film was prepared by the same method as in Example 1, except that the pressure-sensitive adhesive film was prepared by controlling the pressure sensitive adhesive layer to have a thickness of 10 µm, and using a polyolefin film having a thickness of 100 µm.

### Comparative Example 2

A die attach film was prepared by the same method as in Example 1, except that the pressure-sensitive adhesive film was prepared by controlling the pressure sensitive adhesive layer to have a thickness of 40 µm, and using a polyolefin film having a thickness of 70 µm.

### Comparative Example 3

A die attach film was prepared by the same method as in Comparative Example 2, except that the thickness of the adhesive layer for die bonding was controlled to be 5 µm.

The thickness relationship between the layers of the prepared films of the Examples and Comparative Examples are arranged in Table 1 below.

**Table 1**

| | **Example** | | | | **Comparative Example** | | |
|---|---|---|---|---|---|---|---|
| | **1** | **2** | **3** | **4** | **1** | **2** | **3** |
| **Base film (A)(µm)** | 90 | 80 | 80 | 80 | 100 | 70 | 70 |
| **Pressure-sensitive adhesive layer (B)(µm)** | 20 | 30 | 30 | 30 | 10 | 40 | 40 |
| **Adhesive layer (C)(µm)** | 20 | 20 | 60 | 10 | 20 | 20 | 5 |
| **B/A** | 0.222 | 0.375 | 0.375 | 0.375 | 0.1 | 0.571 | 0.571 |
| **B/C** | 1 | 1.5 | 0.5 | 3 | 0.5 | 2 | 8 |

With respect to the die attach film as described above, its physical properties were measured by the following method, and the results are arranged in Table 2 below.

### 1. Burr inhibition characteristic

The die attach film was laminated on a 100 µm wafer and a wafer ring at 50°C using a mounter. Then the wafer was diced using dicing equipment (DAD-640, manufactured by Disco Co. Ltd.) under the conditions: rpm = 40K, speed = 50 mm/sec, chip size = 5 mm×5 mm, and total number = 100. Next, the number of burrs generated on the chips was measured.

### 2. Expanding properties

After the dicing process, the diced wafer was expanded to a range of 5 mm using an expander (HS-1810, manufactured by Huggle Co. Ltd.). Thereby, the expanding properties were estimated.

### 3. Chipping inhibition characteristic

After the dicing process, the chips (total number = 100) having a size of 5 mm×5 mm were peeled off, and then chipping was observed on the lateral faces of each chip. Chippings having a larger size than 20 µm or more in the chip were measured.

### 4. Pick-up characteristic

After the dicing process, a high-pressure mercury lamp having a radiation intensity of 100 mJ/cm² was irradiated, and then the diced chips (total number = 100) were picked up. The case where the chip having the adhesive part was picked up is represented by the symbol O, and the case where a crack was generated or where the chip was not picked up is represented by the symbol X.

**Table 2**

| | **Example** | | | | **Comparative Example** | | |
|---|---|---|---|---|---|---|---|
| | **1** | **2** | **3** | **4** | **1** | **2** | **3** |
| **Number of burrs** | 0 | 0 | 0 | 0 | 6 | 3 | 4 |
| **Number of chippings** | 0 | 0 | 0 | 0 | 2 | 5 | 6 |
| **Pick-up characteristic** | ○ | ○ | ○ | ○ | ○ | ○ | × |

As can be seen from the results of Table 2 above, Examples of the present invention show excellent burr and chipping inhibition characteristics and excellent pick-up characteristics. In contrast, Comparative Example 1, where the value of B/A is less than the range of the present invention, shows that many burrs are generated in the process. Comparative Examples 2 and 3 where the value of B/A exceeds the range of the present invention show that many chippings are generated. Further, Comparative Example 3 where the value of B/C exceeds the range of the present invention shows that many burrs and chippings are generated and the pick-up characteristic is poor.

According to the present invention, a die attach film which can prevent generation of burrs or a chip flying in a dicing process, and exhibits excellent expanding and pick-up characteristics in a die bonding process can be provided. Further, the die attach film can prevent peeling-off of a chip, shifting of a chip, or deflection of a chip during a wire bonding or molding process. Thus, it is possible to improve embeddability, inhibit warpage of a wafer or wiring substrate, and enhance productivity in a semiconductor packaging process, according to the present invention.

While the invention has been shown and described with reference to certain exemplary embodiments thereof, it will be understood by those skilled in the art that various changes in form and details may be made therein without departing from the scope of the invention as defined by the appended claims.

## Claims

1. A die attach film comprising:
a base film;
a pressure-sensitive adhesive part formed on the base film; and
an adhesive part formed on the pressure-sensitive adhesive part,
wherein, when the thicknesses of the base film, the pressure-sensitive adhesive part and the adhesive part are represented by A, B and C, respectively, B/A ranges from 0.15 to 0.5, and B/C ranges from 0.2 to 4.

2. The die attach film according to claim 1, wherein B/A ranges from 0.2 to 0.4.

3. The die attach film according to claim 1, wherein B/C ranges from 0.5 to 3.

4. The die attach film according to claim 1, wherein a difference between the elongation ratio of the base film in a vertical direction and the elongation ratio of the base film in a horizontal direction is not more than 10% of the elongation ratio of the base film in a vertical direction.

5. The die attach film according to claim 1, wherein the base film has a thickness of 10 µm to 200 µm.

6. The die attach film according to claim 1, wherein the pressure-sensitive adhesive part has a thickness of 10 µm to 40 µm.

7. The die attach film according to claim 1, wherein the adhesive part includes an epoxy resin, a high-molecular-weight resin having low elasticity and a hardener.

8. The die attach film according to claim 7, wherein the epoxy resin includes at least one selected from the group consisting of bisphenol A epoxy resin, bisphenol F epoxy resin, cresol novolak epoxy resin, phenol novolak epoxy resin, tetrafunctional epoxy resin, biphenyl-type epoxy resin, a triphenolmethane epoxy resin, alkyl-modified triphenolmethane epoxy resin, naphthalene epoxy resin, dicyclopentadiene epoxy resin, and dicyclopentadiene-modified phenol epoxy resin.

9. The die attach film according to claim 7, wherein the epoxy resin is a mixed resin of a bifunctional epoxy resin and a multifunctional epoxy resin

10. The die attach film according to claim 9, wherein the mixed resin includes 10 to 50 parts by weight of the bifunctional epoxy resin, relative to 100 parts by weight of the multifunctional epoxy resin.

11. The die attach film according to claim 7, wherein the epoxy resin is included in an amount of 10 to 200 parts by weight, relative to 100 parts by weight of the high-molecular-weight resin having low-elasticity .

12. The die attach film according to claim 7, wherein the high-molecular-weight resin having low-elasticity has a glass transition temperature of -20°C to 40°C, and a weight average molecular weight of 100,000 to 1,000,000.

13. The die attach film according to claim 7, wherein the high-molecular-weight resin having low-elasticity includes at least one selected from the group consisting of polyimide, polyetherimide, polyesterimide, polyamide, polyethersulfone, polyetherketone, polyolefin, polyvinyl chloride, phenoxy resin, reactive acrylonitrilbutadiene rubber, and an acrylic resin.

14. The die attach film according to claim 7, wherein the hardener is a phenol resin having a hydroxyl value of 100 to 1,000.

15. The die attach film according to claim 7, wherein the hardener is included in an amount of 30 to 100 parts by weight, relative to 100 parts by weight of the epoxy resin.

16. The die attach film according to claim 7, wherein the adhesive part further includes 0.1 to 10 parts by weight of a curing accelerator, relative to 100 parts by weight of the epoxy resin.

17. The die attach film according to claim 16, wherein the curing accelerator is imidazole compounds, triphenylphosphines or tertiary amine compounds.

18. The die attach film according to claim 1, wherein the adhesive part has a tack force of 50 gf to 150 gf at 130°C.

19. The die attach film according to claim 1, wherein the adhesive part has a shear strength of 4.0 MPa or more at 150°C.

20. The die attach film according to claim 1, wherein the adhesive part has a thickness of 1 µm to 200 µm.

21. A semiconductor wafer comprising the die attach film of claim 1, wherein the adhesive part of the die attach film is attached to one surface of the wafer; and the base film or pressure-sensitive adhesive part of the die attach film is fixed to a ring frame of the wafer.

22. A semiconductor packaging method comprising:
dicing the semiconductor wafer of claim 21; and
picking up a semiconductor chip that is prepared through the dicing step.

## Patentansprüche

1. Chipmontagefilm, umfassend:
einen Basisfilm;
ein Haftklebstoffteil, das auf dem Basisfilm gebildet ist; und
ein Klebstoffteil, das auf dem Haftklebstoffteil gebildet ist,
wobei, wenn die Dicke des Basisfilms, des Haftklebstoffteils und des Klebstoffteils durch A, B bzw. C dargestellt sind, B/A von 0,15 bis 0,5 reicht und B/C von 0,2 bis 4 reicht.

2. Chipmontagefilm nach Anspruch 1, wobei B/A von 0,2 bis 0,4 reicht.

3. Chipmontagefilm nach Anspruch 1, wobei B/C von 0,5 bis 3 reicht.

4. Chipmontagefilm nach Anspruch 1, wobei ein Unterschied zwischen dem Reckverhältnis des Basisfilms in einer vertikalen Richtung und dem Reckverhältnis des Basisfilms in einer horizontalen Richtung nicht mehr als 10% des Reckverhältnisses des Basisfilms in einer vertikalen Richtung ist.

5. Chipmontagefilm nach Anspruch 1, wobei der Basisfilm eine Dicke von 10 µm bis 200 µm aufweist.

6. Chipmontagefilm nach Anspruch 1, wobei der Haftklebstoffteil eine Dicke von 10 µm bis 40 µm aufweist.

7. Chipmontagefilm nach Anspruch 1, wobei das Klebstoffteil ein Epoxidharz, ein Harz mit hohem Molekulargewicht mit geringer Elastizität und ein Härtungsmittel einschließt.

8. Chipmontagefilm nach Anspruch 7, wobei das Epoxidharz wenigstens eines einschließt, das ausgewählt ist aus der Gruppe bestehend aus Bisphenol-A-Epoxidharz, Bisphenol-F-Epoxidharz, Cresol-Novolak-Epoxidharz, Phenol-Novolak-Epoxidharz, tetrafunktionellem Epoxidharz, biphenylartigem Epoxidharz, einem Triphenolmethanepoxidharz, Alky-modifiziertem Triphenolmethanepoxidharz, Naphthalenepoxidharz, Dicyclopentadienepoxidharz und Dicyclopentadien-modifiziertem Phenolepoxidharz.

9. Chipmontagefilm nach Anspruch 7, wobei das Epoxidharz ein gemischtes Harz aus einem bifunktionellen Epoxidharz und einem mehrfunktionellen Epoxidharz ist.

10. Chipmontagefilm nach Anspruch 9, wobei das gemischte Harz 10 bis 50 Gewichtsteile des bifunktionellen Epoxidharzes, relativ zu 100 Gewichtsteilen des mehrfunktionellen Epoxidharzes, einschließt.

11. Chipmontagefilm nach Anspruch 7, wobei das Epoxidharz in einer Menge von 10 bis 200 Gewichtsteilen, relativ zu 100 Gewichtsteilen des Harzes mit hohem Molekulargewicht mit geringer Elastizität, eingeschlossen ist.

12. Chipmontagefilm nach Anspruch 7, wobei das Harz mit hohem Molekulargewicht mit geringer Elastizität eine Glasübergangstemperatur von -20°C bis 40°C und ein Gewichtsmittelmolekulargewicht von 100.000 bis 1.000.000 aufweist.

13. Chipmontagefilm nach Anspruch 7, wobei das Harz mit hohem Molekulargewicht mit geringer Elastizität wenigstens eines einschließt, das ausgewählt ist aus der Gruppe bestehend aus Polyimid, Polyetherimid, Polyesterimid, Polyamid, Polyethersulfon, Polyetherketon, Polyolefin, Polyvinylchlorid, Phenoxyharz, reaktivem Acrylnitrilbutadienkautschuk und einem Acrylharz.

14. Chipmontagefilm nach Anspruch 7, wobei das Härtungsmittel ein Phenolharz mit einer Hydroxylzahl von 100 bis 1.000 ist.

15. Chipmontagefilm nach Anspruch 7, wobei das Härtungsmittel in einer Menge von 30 bis 100 Gewichtsteilen, relativ zu 100 Gewichtsteilen des Epoxidharzes, eingeschlossen ist.

16. Chipmontagefilm nach Anspruch 7, wobei das Klebstoffteil ferner 0,1 bis 10 Gewichtsteile eines Härtungsbeschleunigers, relativ zu 100 Gewichtsteilen des Epoxidharzes, einschließt.

17. Chipmontagefilm nach Anspruch 16, wobei der Härtungsbeschleuniger Imidazolverbindungen, Triphenylphosphine oder tertiäre Aminverbindungen ist.

18. Chipmontagefilm nach Anspruch 1, wobei das Klebstoffteil eine Haftstärke von 50 gf bis 150 gf bei 130°C aufweist.

19. Chipmontagefilm nach Anspruch 1, wobei das Klebstoffteil eine Scherstärke von 4,0 MPa oder mehr bei 150°C aufweist.

20. Chipmontagefilm nach Anspruch 1, wobei das Klebstoffteil eine Dicke von 1 µm bis 200 µm aufweist.

21. Halbleiterwafer umfassend den Chipmontagefilm nach Anspruch 1, wobei das Klebstoffteil des Chipmontagefilms an einer Oberfläche des Wafers angefügt ist; und wobei der Basisfilm oder das Haftklebstoffteil des Chipmontagefilms an einem Ringrahmen des Wafers befestigt ist.

22. Halbleiterpackungsverfahren, umfassend:
Würfeln des Halbleiterwafers nach Anspruch 21; und
Aufnehmen eines Halbleiterchips, der durch den Würfelschritt hergestellt wird.

## Revendications

1. Couche mince de fixation de puce comprenant :
une couche de base ;
une partie adhésive sensible à la pression formée sur la couche de base ; et
une partie adhésive formée sur la partie adhésive sensible à la pression, dans laquelle, lorsque l'épaisseur de la couche de base, de la partie adhésive sensible à la pression et de la partie adhésive sont représentées respectivement par A, B et C, B/A oscille entre 0,15 et 0,5 et B/C oscille entre 0,2 et 4.

2. Couche mince de fixation de puce selon la revendication 1, dans laquelle B/A oscille entre 0,2 et 0,4.

3. Couche mince de fixation de puce selon la revendication 1, dans laquelle B/C oscille entre 0,5 et 3.

4. Couche mince de fixation de puce selon la revendication 1, dans laquelle une différence entre le rapport d'allongement de la couche de base dans une direction verticale et le rapport d'allongement de la couche de base dans une direction horizontale n'est pas supérieure à 10 % du rapport d'allongement du film de base dans une direction verticale.

5. Couche mince de fixation de puce selon la revendication 1, dans laquelle la couche de base a une épaisseur de 10 µm à 200 µm.

6. Couche mince de fixation de puce selon la revendication 1, dans laquelle la partie adhésive sensible à la pression a une épaisseur de 10 µm à 40 µm.

7. Couche mince de fixation de puce selon la revendication 1, dans laquelle la partie adhésive contient une résine époxy, une résine à poids moléculaire élevé ayant une faible élasticité et un durcisseur.

8. Couche mince de fixation de puce selon la revendication 7, dans laquelle le résine époxy contient au moins un composé sélectionné dans le groupe constitué de résine époxy bisphénol A, de résine époxy bisphénol F, de résine époxy novolaque de crésol, de résine époxy novolaque de phénol, de résine époxy tétrafonctionnelle, de résine époxy de type biphényle, de résine époxy de triphénolméthane, de résine époxy de triphénolméthane modifiée par l'alkyle, de résine époxy de napthtalène, de résine époxy de dicyclopentadiène et de résine époxy modifiée par le dicyclopentadiène.

9. Couche mince de fixation de puce selon la revendication 7, dans laquelle la résine époxy est une résine mélangée composée d'une résine époxy bifonctionnelle et d'une résine époxy multifonctionnelle.

10. Couche mince de fixation de puce selon la revendication 9, dans laquelle la résine mélangée contient 10 à 50 parties en poids de résine époxy bifonctionnelle, par rapport à 100 parties en poids de la résine époxy multifonctionnelle.

11. Couche mince de fixation de puce selon la revendication 7, dans laquelle la résine époxy est incorporée en une quantité de 10 à 200 parties en poids, par rapport à 100 parties en poids de la résine de poids moléculaire élevé ayant une faible élasticité.

12. Couche mince de fixation de puce selon la revendication 7, dans laquelle la résine de poids moléculaire élevé ayant une faible élasticité à une température de transition vitreuse de -20 °C à 40 °C et un poids moléculaire moyen en poids de 100.000 à 1.000.000.

13. Couche mince de fixation de puce selon la revendication 7, dans laquelle la résine de poids moléculaire élevé ayant une faible élasticité contient au moins un composé sélectionné dans le groupe constitué de polyimide, de polyétherimide, de polyesterimide, de polyamide, de polyéthersulfone, de polyéthercétone, de polyoléfine, de chlorure de polyvinyle, de résine phénoxy, de caoutchouc d'acrylonibutadiène réactif et d'une résine acrylique.

14. Couche mince de fixation de puce selon la revendication 7, dans laquelle le durcisseur est une résine de phénol ayant une valeur hydroxyle de 100 à 1.000.

15. Couche mince de fixation de puce selon la revendication 7, dans laquelle le durcisseur est incorporé en une quantité de 30 à 100 parties en poids, par rapport à 100 parties en poids de la résine époxy.

16. Couche mince de fixation de puce selon la revendication 7, dans laquelle la partie adhésive contient en outre 0,1 à 10 parties en poids d'un accélérateur de durcissement, par rapport à 100 parties en poids de la résine époxy.

17. Couche mince de fixation de puce selon la revendication 16, dans laquelle l'accélérateur de durcissement est constitué de composés d'imidazole, de triphénylphosphines ou de composés d'amine tertiaire.

18. Couche mince de fixation de puce selon la revendication 1, dans laquelle la partie adhésive a une force opérationnelle de 50 gf à 150 gf à 130 °C.

19. Couche mince de fixation de puce selon la revendication 1, dans laquelle la partie adhésive à une résistance au cisaillement de 4,0 MPa ou supérieure à 150 °C.

20. Couche mince de fixation de puce selon la revendication 1, dans laquelle la partie adhésive a une épaisseur de 1 µm à 200 µm.

21. Plaquette de semi-conducteur comprenant la couche mince de fixation de puce selon la revendication 1,
dans laquelle la partie adhésive de la couche de fixation de puce est fixée à une surface de la plaquette ; et la couche de base ou la partie adhésive sensible à la pression de la couche mince de fixation de puce est fixée à un cadre annulaire de la plaquette.

22. Procédé de conditionnement d'un semi-conducteur comprenant les étapes consistant à :
découper la plaquette de semi-conducteur selon la revendication 21 ; et
récupérer une puce semi-conductrice qui est préparée par le biais de l'étape de découpage.
